# EUROPEAN PATENT APPLICATION

(11) **EP 4 815 652 A1**
(43) Date of publication of application: **30.09.2026**
(21) Application number: 25217806.6
(22) Date of filing: 21.11.2025
(51) Int. Cl.: H05K 7/20, G06F 1/20

(54) **METHODS AND APPARATUS TO IMPROVE COOLING OF DUAL IN-LINE MEMORY MODULES**

(30) Priority: 28.03.2025 US 202519093840
(71) Applicant: Intel Corporation, Santa Clara, CA 95054 (US)
(72) Inventor: TIEN, Ming-Wei, 11561 Taipei (TW); LIU, Abby, 203001 Keelung City (TW); CHUANG, Chi-Hung, 115 Taipei (TW); KUO, Chun-Yi, 505019 Hsinchu City (TW); WU, Meng-Hsun, 100022 Taipei (TW); WU, Dong-Han, 242032 New-Taipei, Xinzhuang Dist. (TW)
(74) Representative: Maiwald GmbH

(57) **Abstract**

Systems, apparatus, articles of manufacture, and methods to improve cooling of dual in-line memory modules are disclosed. An example apparatus includes a heat pipe to extend between first and second dual in-line memory modules (DIMMs). A first end of the heat pipe extends beyond a first end of the first and second DIMMs. A second end of the heat pipe extends beyond a second end of the first and second DIMMs. The example apparatus further includes an array of fins thermally coupled to the first end of the heat pipe.

## Description

### BACKGROUND

With the rise of "big data" applications, artificial intelligence (AI) applications, and other high performance and/or centralized computing (e.g., "cloud computing") applications, processor chips are being pushed to higher and higher levels of performance. Furthermore, there is an ever increasing demand for more memory capacity to operate in conjunction with higher performance processor chips. Efforts to meet increasing memory demands include improving the performance and/or density of transistors on a given memory chip and/or implementing systems that include a greater number of memory chips.

### BRIEF DESCRIPTION OF THE DRAWINGS

FIG. 1 illustrates an example server assembly constructed in accordance with teachings disclosed herein.
FIG. 2 is a perspective view of the example heat sink assembly of FIG. 1 with the motherboard and DIMMs omitted.
FIG. 3 is a top view of the example heat sink assembly on the motherboard of FIG. 1.
FIG. 4 is a top view of the example heat sink assembly similar to FIG. 3, but with the motherboard and DIMMs omitted.
FIG. 5 is a cross-sectional view of the example heat sink assembly on the motherboard taken along the line 5-5 shown in FIG. 3.
FIG. 6 is a cross-sectional view of the example heat sink assembly similar to FIG. 5, but with the motherboard and DIMMs omitted.
FIG. 7 is a side view of the example heat sink assembly on the motherboard of FIG. 1.
FIG. 8 is a side view of the example heat sink assembly similar to FIG. 7, but with the motherboard and DIMMs omitted.
FIG. 9 is a bottom perspective view of the heat sink assembly showing an example third array of fins.
FIG. 10 illustrates an example heat pipe and an associated example heat spreader of the example heat sink assembly of FIGS. 1-9 sandwiched between two DIMMs.
FIG. 11 is a flowchart representative of an example method of manufacturing the example heat sink assembly of FIGS. 1-10.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

### DETAILED DESCRIPTION

With the explosive growth in demand for AI, machine learning, and large language models, there is a need to process a vast number of parameters during the training phase. To handle these parameters, more memory capacity is needed for batch processing, leading to an increased demand for dual in-line memory module (DIMM) slots in servers. Moreover, there is an increased demand for higher performance processor chips (e.g., CPU packages) to process the large amounts of data. Such increases in demand for processor performance are being met by larger and larger processor chips, which leave less room for the DIMM slots on a server. The challenge of fitting an increasing number of DIMM slots on a motherboard for a server is exacerbated by the fact that motherboards for servers are generally constrained in size to fit within standard 19-inch racks. One solution is to position the DIMM slots closer together. Specifically, known motherboards include DIMM slots spaced at a pitch of 0.297 inches. Examples disclosed herein include DIMM slots at a pitch or spacing of less than 0.29 inches (e.g., less than or equal to 0.28 inches, less than or equal to 0.27 inches, less than or equal to 0.26 inches, less than or equal to 0.25 inches etc.). While the smaller pitch enables DIMMs to be fit within a smaller area, positioning DIMMs closer together creates challenges for the proper dissipation of heat produced by such DIMMs. Specifically, DIMMs are often cooled by forced air blowing across and between adjacent DIMMs. By positioning DIMMs closer together there is less space for cooled air to pass through and draw away heat.

The dissipation of heat from DIMMs is made more challenging as the performance of memory chips have increased (e.g., from 3600 megatransfers per second (MT/s) to 8800 MT/s), which is associated with a significant increase in power consumption and an associated increase in heat generation. More particularly, some known DDR5-3200 DIMMs consume about 10 watts (W) per DIMM, whereas some known DDR5-8800 DIMMs that use multiplexer combined ranks (MCR) consume approximately 22 W per DIMM.

Challenges associated with the dissipation of heat from DIMMs can be further exacerbated by the environment in which the DIMMs are implemented. Many servers are implemented within temperature-controlled rooms in datacenters. However, for edge computing and/or edge AI applications, a server may be implemented in a small enclosure that is subject to fluctuating temperatures based on weather conditions in the local area. As a result, system operation temperatures can be much higher (e.g., up to as much as 65 degrees Celsius (°C) or more) than faced in a temperature-controlled room inside a datacenter.

Past approaches to address DIMM cooling include applying limits to the DIMM thermal design power (TDP) based on the system cooling capacity. However, this approach results in some higher-bandwidth and/or higher-performance DIMM models being compromised. Another known approach is to implement closed loop thermal throttling (CLTT) based on a thermal sensor on a given DIMM. However, throttling negatively impacts performance in a manner that is insufficient to adequately meet the demands of AI and/or other high performance applications that are becoming increasingly important.

Examples disclosed herein involve an enhanced volume air cooling (EVAC) solution based on a heat sink assembly structured to improve thermal heat dissipation from DIMMs spaced with a narrower pitch than known approaches without the need for throttling or other performance inhibiting actions. More particularly, example EVAC solutions include DIMM heat spreaders positioned adjacent corresponding DIMMs (and/or between an adjacent pair of DIMMs). The DIMM heat spreaders are thermally coupled to corresponding flattened heat pipes that extend to outrigger fin arrays adjacent one or both ends of the DIMMs. The fin arrays are aligned with the direction of airflow travel for cooling air. Thus, heat generated by the DIMMs is drawn away by the heat spreaders to the heat pipes that then transfer heat to the fin arrays where the heat is finally transferred to cooled air passing over the system.

Simulated and experimental testing has shown examples disclosed herein provided enhanced cooling relative to previously known approaches to enable DIMMs to be positioned closer together without concerns of overheating and/or to enable the implementation of higher performance DIMMs than previously possible. More specifically, simulated experiments indicate that example EVAC solutions disclosed herein reduce DIMM temperature by more than 20 degrees Celsius and reduce thermal resistance by more than 1 degree Celsius per watt (C/W) relative to DIMMs cooled using forced air without the example EVAC solutions. Furthermore, such reductions in DIMM temperature were also realized in simulated high operating temperature environments making the example EVAC solutions disclosed herein a suitable option to implement in edge computing applications where a server can be exposed to relatively extreme temperatures based on local weather patterns. Additionally, such reductions in temperature are achieved through forced air rather than more expensive liquid cooling systems (e.g., a cold plate and/or submersion cooling systems) that introduce concerns of coolant leakage. Furthermore, the more efficient cooling enabled by examples disclosed herein conserves power by enabling fan power and/or fan rotations per minute (RPMs) to be reduced relatively to known air cooling solutions.

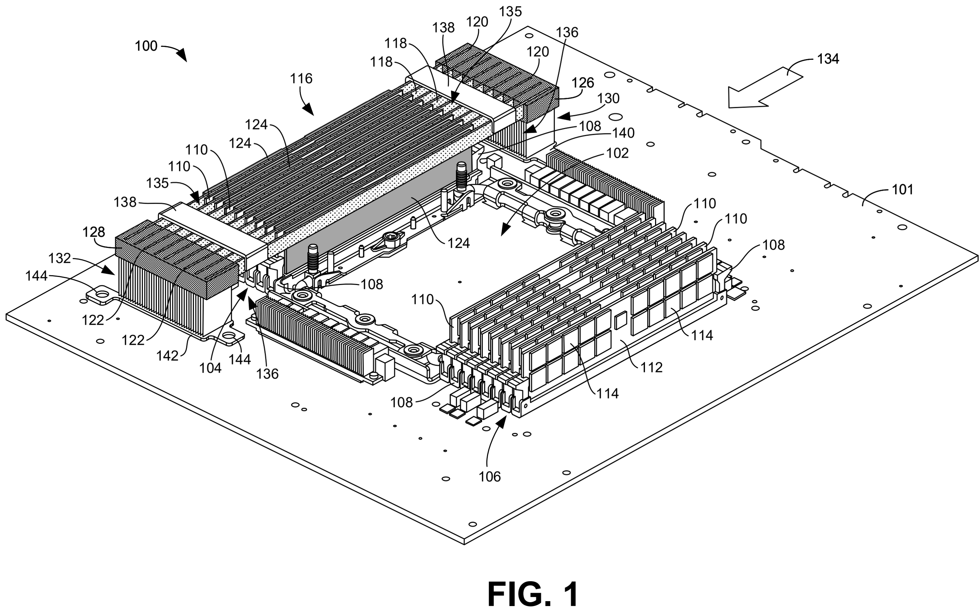

FIG. 1 illustrates an example server assembly 100 constructed in accordance with teachings disclosed herein. In this example, the server assembly 100 includes a motherboard 101 (e.g., server board, a main printed circuit board) that includes a processor socket 102 positioned between two (e.g., first and second) banks 104, 106 (e.g., DIMM banks) of DIMM slots 108 (e.g., DIMM sockets). The processor socket 102 is constructed to receive a corresponding processor chip (e.g., processor die, integrated circuit (IC) package, etc.), which has been omitted for the sake of clarity. Further, in the illustrated example of FIG. 1, each DIMM slot 108 includes a corresponding DIMM 110 (e.g., memory card, memory stick, memory board, etc.) inserted therein to define an array of DIMMs 110. As shown in the illustrated example, the DIMMs 110 include a base circuit board 112 (e.g., a printed circuit board (PCB)) and a plurality of memory chips 114 (e.g., memory dies) mounted thereon. In some examples, all of the memory chips 114 of a given DIMM 110 are mounted to the same side of the corresponding base circuit board 112. In other examples, the memory chips 114 are mounted to both sides of the corresponding base circuit board 112. In some examples, the DIMMs 110 include a greater or smaller number of memory chips 114 than what is shown in the illustrated example.

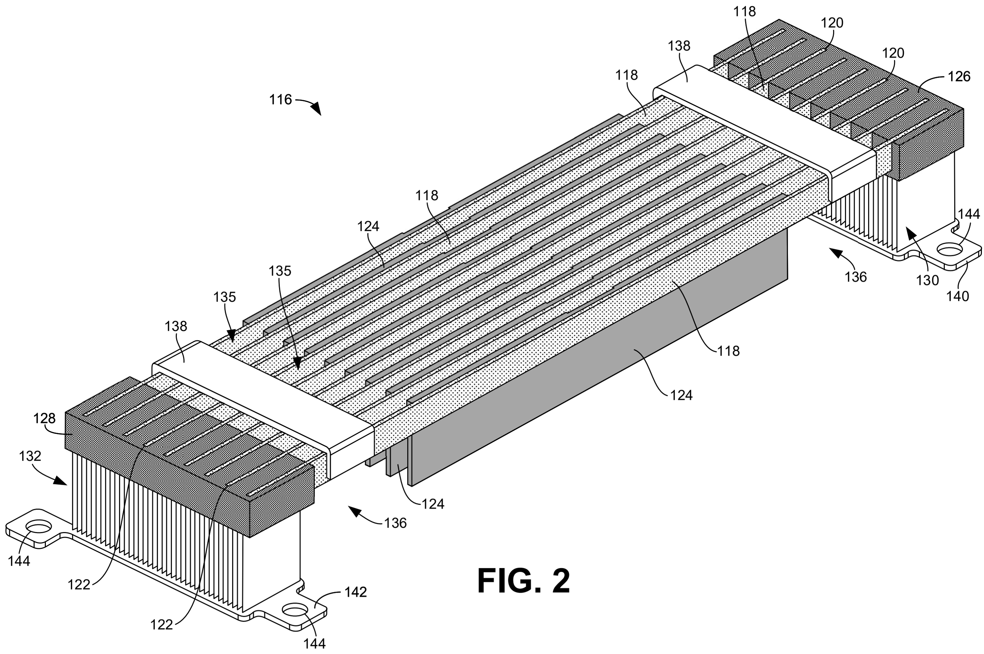

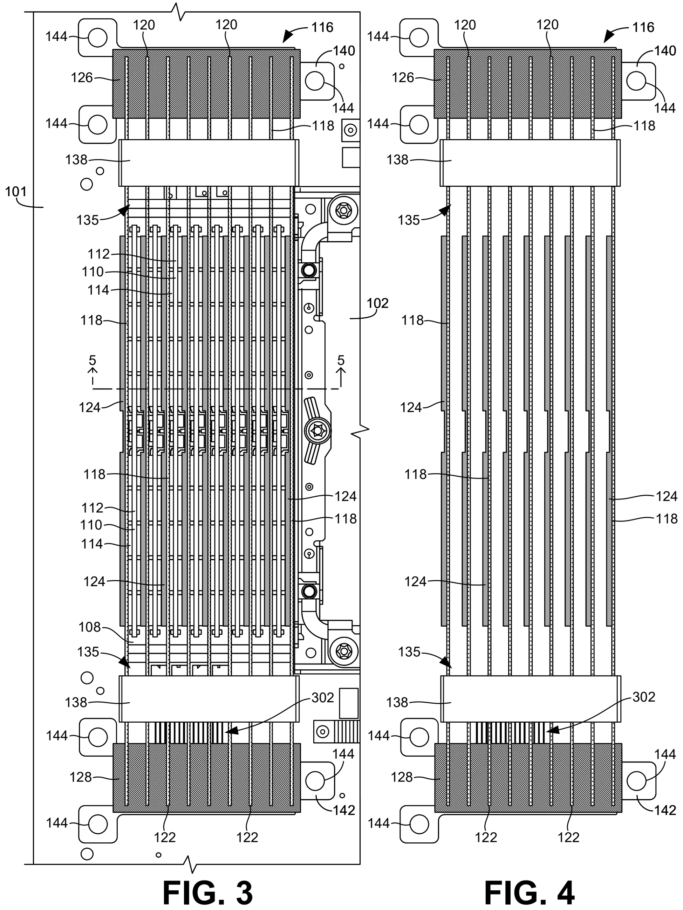

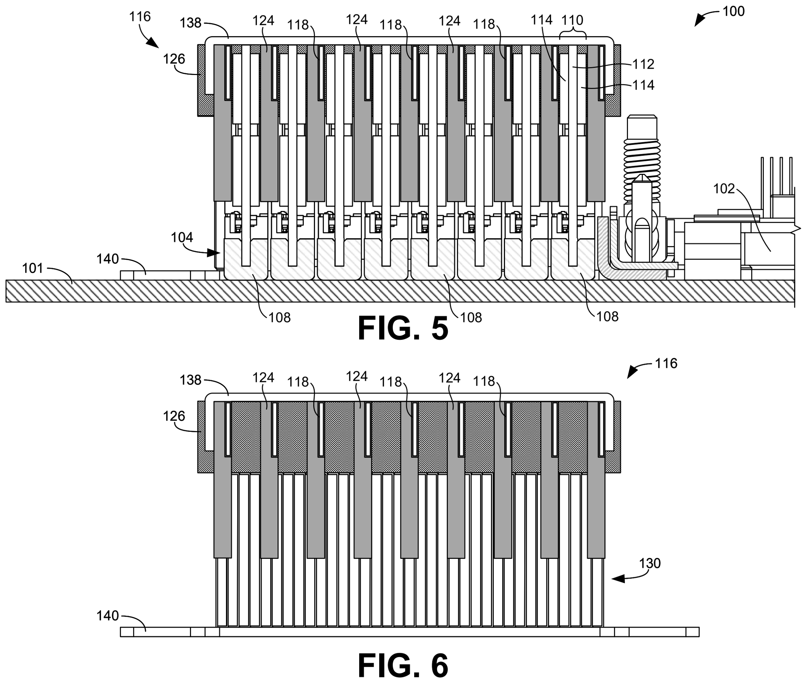

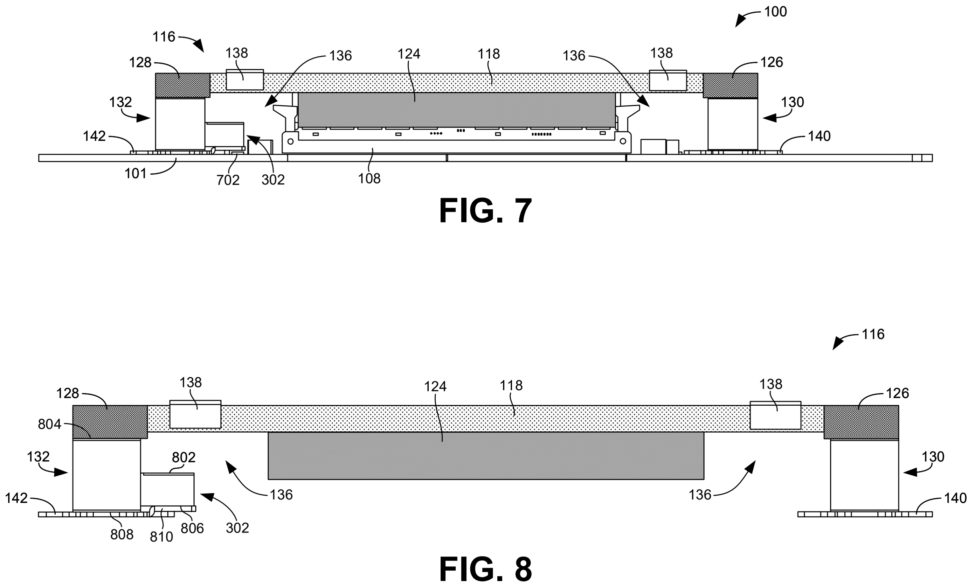

In the example of FIG. 1, an example heat sink assembly 116 (e.g., an EVAC solution) is positioned adjacent to and between the DIMMs 110 in the first bank 104 of DIMM slots 108. In some examples, a similar heat sink assembly 116 is also positioned adjacent the DIMMs 110 in the second bank 106. However, the heat sink assembly 116 associated with the second bank 106 is omitted for purposes of explanation. FIG. 2-8 illustrate different views of the example heat sink assembly 116 of FIG. 1. Specifically, FIG. 2 is a perspective view of the example heat sink assembly 116 of FIG. 1 with the motherboard 101 and DIMMs 110 omitted. FIG. 3 is a top view of the example heat sink assembly 116 on the motherboard 101 of FIG. 1. FIG. 4 is a top view of the example heat sink assembly 116 similar to FIG. 3, but with the motherboard 101 and DIMMs 110 omitted. FIG. 5 is a cross-sectional view of the example heat sink assembly 116 on the motherboard 101 taken along the line 5-5 shown in FIG. 3. FIG. 6 is a cross-sectional view of the example heat sink assembly 116 similar to FIG. 5, but with the motherboard 101 and DIMMs 110 omitted. FIG. 7 is a side view of the example heat sink assembly 116 on the motherboard 101 of FIG. 1. FIG. 8 is a side view of the example heat sink assembly 116 similar to FIG. 7, but with the motherboard 101 and DIMMs 110 omitted.

In the illustrated example, each of the banks 104, 106 includes a row of eight DIMM slots 108 that are spaced apart at a pitch of approximately 0.26 inches (e.g., 0.26 +/-0.005 inches) corresponding to 6.6 millimeters (mm). In other examples, the banks 104, 106 include a greater or smaller number of DIMM slots 108 than the eight shown. Further, in some examples, the DIMM slots 108 can be spaced apart at any other suitable pitch including 0.297 inches (that is implemented on many known motherboards) and/or including smaller pitches (e.g., less than or equal to 0.29 inches, less than or equal to 0.28 inches, less than or equal to 0.27 inches, less than or equal to 0.26 inches, less than or equal to 0.25 inches etc.). In the illustrated example, the thickness of the DIMMs 110 (including the base circuit board 112 and the memory chips 114 mounted thereon) is approximately 0.13 inches (e.g., 3.3 mm). With a spacing of the DIMM slots 108 being at a pitch of 0.26 inches, the gap or space between adjacent DIMMs 110 is approximately 0.13 inches (e.g., 3.3 mm).

As shown in the illustrated example, portions of the heat sink assembly 116 extend through the gap between adjacent pairs of the DIMMs 110 to facilitate heat transfer away from the DIMMs 110. More particularly, in some examples, the heat sink assembly 116 includes a plurality of heat pipes 118 positioned between adjacent pairs of the DIMMs 110 near a top edge of the DIMMs 110. As used in this context, the top edge of the DIMMs 110 corresponds to the edge of the DIMMs 110 farthest away (e.g., facing away) from the motherboard 101.

In some examples, as shown most clearly in the cross-sectional views of FIGS. 5 and 6, the heat pipes 118 are hollow to include a liquid coolant that can evaporate (e.g., boil) and condense to facilitate the transfer of heat along the length of the heat pipes 118 and, more particularly, from a central region of the heat pipes 118 (where the DIMMs 110 are located) to opposing first and second ends 120, 122 of the heat pipes 118. In some examples, the wall of the heat pipes 118 includes any suitable thermally conductive material (e.g., copper, aluminum alloy, etc.. In some examples, the heat pipes 118 are relatively flat or narrow, meaning that the heat pipes 118 have a cross-section defined by a width (or height) that is multiple times greater than a thickness, similar to a vapor chamber. Thus, in some examples, the heat pipes 118 can be implemented by and/or referred to as vapor chambers. In some examples, the heat pipes 118 have a length that is multiple times greater than the height. More particularly, in some examples, the lengths of the heat pipes 118 are significantly longer than the DIMMs. In this context, the width or height of the heat pipes 118 corresponds to the dimension measured in a direction perpendicular to the motherboard 101, the thickness of the heat pipes 118 corresponds to the dimension measured in a direction perpendicular to the DIMMs 110, and the length of the heat pipes 118 corresponds to the dimension measured in a direction parallel to both the motherboard 101 and the DIMMs 110.

In the illustrated example, the heat sink assembly 116 also includes a plurality of heat spreaders 124, with different ones of the heat spreaders 124 attached to corresponding ones of the heat pipes 118. Thus, as with the heat pipes 118, the heat spreaders 124 are positioned between adjacent pairs of the DIMMs 110. In some examples, in addition to extending between adjacent pairs of the DIMMs 110, the heat sink assembly 116 includes heat pipes 118 and corresponding heat spreaders 124 positioned on the outer side of the outermost DIMMs 110. Thus, in some examples, each DIMM 110 is sandwiched between two heat pipes 118 and two heat spreaders 124. In other words, in some examples, at least one heat pipe 118 is closer to the processor socket 102 than a closest one of the DIMMs 110 in the first bank 104 is to the processor socket 102. Further, in some examples, at least one heat pipe 118 is farther away from the processor socket 102 than a farthest one of the DIMMs 110 in the first bank 104 is to the processor socket 102.

In some examples, the heat spreaders 124 are a solid slab or sheet of thermally conductive material (e.g., copper, aluminum alloy, etc.). In some examples, the heat spreaders 124 have a shorter length than the heat pipes 118 (measured in a direction parallel to the DIMMs 110 and parallel to the motherboard 101). More particularly, in some examples, the heat spreaders 124 have a length approximately corresponding to the length of the DIMMs 110. By contrast, the heat pipes 118 have a length that extends significantly beyond ends of the DIMMs 110. In some examples, the heat spreaders 124 can be longer or shorter than what is shown in the illustrated example. However, in some examples, the heat spreaders 124 are at least long enough to cover and/or interface with a substantial majority (e.g., all) of the outward facing surfaces of the memory chips 114 on the DIMMs 110. Although the heat spreaders 124 are shorter in length than the heat pipes 118, in some examples, the heat spreaders 124 have a larger width (or height). Specifically, in some examples, the heat spreaders 124 extend downward from the heat pipes 118 (e.g., towards the motherboard 101) a majority of the width (or height) of the corresponding DIMMs 110. More particularly, in some examples, the width (or height) of the heat spreaders 124 are sufficient to cover and/or interface with a substantial majority (e.g., all) of the outward facing surfaces of the memory chips 114 on the DIMMs 110.

The heat spreaders 124 are dimensioned to cover and/or interface with the memory chips 114 on the DIMMs 110 so as to absorb heat produced by the memory chips 114. As heat is absorbed by the heat spreaders 124, the heat is transferred to the heat pipes 118 and along the length of the heat pipes 118 (e.g., by evaporation and condensation of liquid within the heat pipes 118) to the first and second ends 120, 122 of the heat pipes 118. As shown in the illustrated example, the ends 120, 122 of the heat pipes 118 are thermally coupled to (e.g., embedded within) first and second thermally conductive slabs 126, 128 that are supported by corresponding first and second arrays of fins 130, 132. Based on this arrangement, heat is passed from the heat pipes 118, through the thermally conductive slabs 126, 128, and to the arrays of fins 130, 132 before being dissipated to cooled air blown across the server assembly 100. In this example, both the fins in the arrays of fins 130, 132 and the DIMMs 110 are oriented to extend in planes that are substantially parallel to one another and substantially parallel to a direction 134 of airflow of the cooled air to improve cooling efficiency by enabling the air to pass through the fins in the arrays of fins 130, 132. As used herein, substantially parallel is defined to mean within 5 degrees of exactly parallel.

In some examples, the heat pipes 118 and the heat spreaders 124 substantially fill the gap or space between adjacent pairs of the DIMMs 110 such that relatively little air passes through or between the DIMMs 110. Accordingly, in some examples, the second array of fins 132 (and the associated second thermally conductive slab 128), which is downstream from the heat spreaders 124, is spaced apart from the heat spreaders 124 (and the associated DIMMs 110) to provide first gaps 135 between the heat pipes 118 through which air can pass (after crossing over top of the DIMMs 110 and the rest of the heat sink assembly 116) to reach the second (downstream) array of fins 132. Further, the separation between the second array of fins 132 (and the associated second thermally conductive slab 128) and the heat spreaders 124 (and the associated DIMMs 110) also provides second gaps 136 underneath the heat pipes 118 through which air can pass (after extending along either side of the DIMMs 110) to reach the second (downstream) array of fins 132. In some examples, similar spaces or gaps 135, 136 are provided between the first (upstream) array of fins 130 and the heat spreaders 124 (and the associated DIMMs 110).

In some examples, the space between the arrays of fins 130, 132 (and the associated thermally conductive slabs 126, 128) and the heat spreaders 124 (and the associated DIMMs 110) is additionally and/or alternatively provided to allow room for other components on the motherboard 101. In some such examples, these other components (such as voltage regulator components) are thermally coupled to the arrays of fins 130, 132 so that the fins help dissipate heat from these other components as discussed further below. In some examples, the space or distance between the heat spreaders 124 (and the associated DIMMs 110) and the first (upstream) array of fins 130 is different from the space or distance between the heat spreaders 124 (and the associated DIMMs 110) and the second (downstream) array of fins 130.

In some examples, one or more clips 138 are attached to the heat pipes 118 at a location corresponding to the space between the DIMMs 110 and the array of fins 130, 132 (and the associated thermally conductive slabs 126). In some examples, the clips 138 provide structural support to the heat pipes 118 along the space between the DIMMs 110 and the ends 120, 122 of the heat pipes within the thermally conductive slabs 126, 128. In some examples, the clips 138 include any suitable material more rigid than the heat pipes 118 (e.g., stainless steel, aluminum alloy, etc.). In some examples, the material for the clips 138 is thermally conductive to facilitate heat transfer between the heat pipes 118. In some examples, one or more (e.g., all) of the clips 138 are omitted.

In some examples, the heat sink assembly 116 includes a first mounting bracket 140 attached to the bottom side of the first array of fins 130 (e.g., opposite the first thermally conductive slab 126) and a second mounting bracket 142 attached to the bottom side of the second array of fins 132 (e.g., opposite the second thermally conductive slab 128). In some examples, the mounting brackets 140, 142 include one or more mounting holes 144 to attach the heat sink assembly 116 to the motherboard 101 (e.g., via corresponding threaded fasteners). In some examples, the shape of the mounting bracket 140, 142 and/or the positions of the mounting holes 144 can differ from what is shown in the illustrated example.

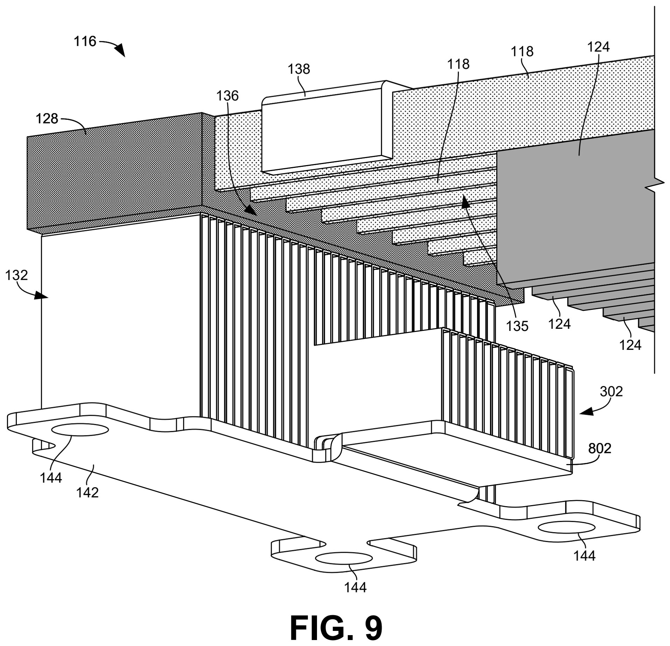

As is visible through the gaps 135 between the heat pipes 118 adjacent the second thermally conductive slab 128 in FIGS. 3 and 4, and more clearly shown in FIGS. 7 and 8, the example heat sink assembly 116 includes a third array of fins 302. FIG. 9 is a bottom perspective view of the heat sink assembly 116 showing the third array of fins 302 in greater detail. In this example, the third array of fins 302 is an extension of a subset of the fins in the second array of fins 132. That is, the fins in the third array 302 are continuous extensions of corresponding fins in the second array 132. In some examples, all of the fins in the second array 132 include an extending or protruding portion corresponding to fins in the third array 302. In some examples, the third array of fins 302 have a same height as the second array of fins 302 from which the third array of fins 302 extends. However, in other instances, as shown in the illustrated example, the third array of fins 302 includes fins that are shorter than the second array of fins 132. More particularly, as identified in FIG. 8, the top edge 802 of the fins in the third array of fins 302 is lower than the top edge 804 of the fins in the first array of fins 132. Further, the bottom edge 806 of the fins in the third array of fins 302 is higher than the bottom edge 808 of the fins in the first array of fins 132. In some examples, the bottom edge 806 of the fins in the third array of fins 302 rests on (e.g., is attached to and/or supported by) a raised platform 810 of the second mounting bracket 142. In some examples, the raised platform 810 is dimensioned to be positioned over top of voltage regulator components 702 (shown in FIG. 7) attached to the motherboard 101. More particularly, in some examples, the raised platform 810 is thermally coupled to the voltage regulator components 702 (e.g., directly and/or via a thermal interface material) so that heat generated by the voltage regulator components 702 can be transferred through to the raised platform to the third array of fins 302 to be dissipated to the cooled air blown across the server assembly 100. In some such examples, a separate heat sink for the voltage regulator components 702 can be eliminated and/or reduced in size. In some examples, to facilitate alignment of the heat sink assembly 116 with the voltage regulator components 702, the mounting holes 144 in the mounting brackets 140, 142 are positioned to align with mounting holes associated with the voltage regulator components 702.

In the illustrated example, as noted above, the third array of fins 302 is adjacent to (and an extension of) the second array of fins 132. In some examples, the third array of fins 302 is adjacent to (and an extension of) the first array of fins 130. In some examples, both the first and second arrays of fins 130, 132 include corresponding smaller arrays of fins similar to the third array of fins 302. Thus, the third array of fins 302 can be positioned upstream and/or downstream of the DIMMs 110. In the illustrated example, the third array of fins 302 is shown and described as being closer to the heat spreaders 124 than either of the first or second arrays of fins 130, 132 is to the heat spreaders 124. That is, in some examples, the third (smaller) array of fins 302 is between the second (larger) array of fins 132 (and/or the first array of fins 130) and the heat spreaders 124. In other examples, the third array of fins 302 is farther away from the heat spreaders 124 than either of the first or second arrays of fins 130, 132 is to the heat spreaders 124. That is, in some examples, the second (larger) array of fins 132 (and/or the first array of fins 130) is between the third (smaller) array of fins 302 and the heat spreaders 124. In some examples, the third array of fins 302 is omitted. In some such examples, the associated raised platform 810 is also omitted.

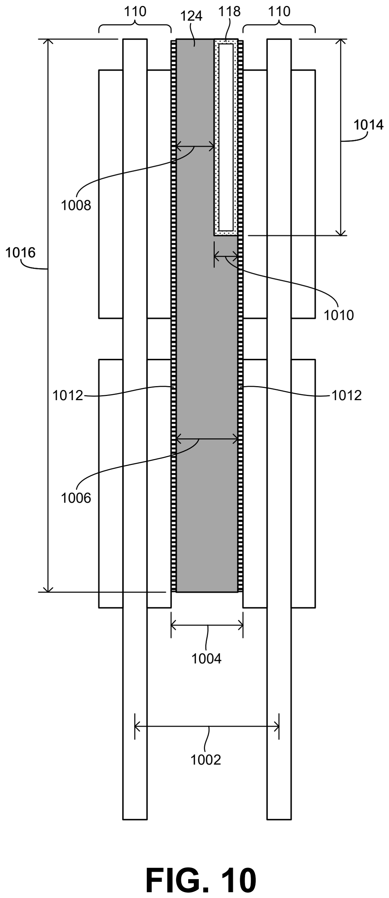

FIG. 10 illustrates an example heat pipe 118 and an associated example heat spreader 124 of the example heat sink assembly 116 of FIGS. 1-9 sandwiched between two DIMMs 110. In this example, the DIMMs 110 are spaced apart at a pitch 1002 corresponding to approximately 0.26 inches (e.g., 0.26 +/- 0.005 inches) corresponding to approximately 6.6 mm with a gap or distance 1004 between the DIMMs 110 corresponding to approximately 0.13 inches (e.g., 0.13 +/- 0.005 inches) corresponding to approximately 3.3 mm. As shown in the illustrated example, the heat spreader 124 substantially fills the space between the DIMMs 110 with a first thickness 1006 (e.g., main thickness) of approximately 0.12 inches (e.g., 0.12 +/- 0.005 inches) corresponding to approximately 3.1 mm. In this example, the heat spreader 124 includes a second (narrower) thickness 1008 (e.g., reduced thickness) to accommodate the heat pipe 118. In some examples, the second thickness 1008 is approximately 0.08 inches (e.g., 0.08 +/- 0.005 inches) corresponding to approximately 2.1 mm. In such examples, a thickness 1010 of the heat pipe 118 is approximately 0.04 inches (e.g., 0.04 +/- 0.005 inches) corresponding to approximately 1 mm. Thus, in this example, the thickness of the heat pipe 118 and the second thickness 1008 of the heat spreader 124 collectively correspond to the first thickness 1006 of the heat spreader 124. The dimensions outlined above leave approximately 0.004 inches (e.g., 0.004 +/- 0.002 inches) corresponding to approximately 0.1 mm on either side of the heat spreader 124 to be filled by an example thermal interface material 1012 (e.g., a thermal interface pad). The thermal interface material 1012 ensures reliable thermal coupling of the DIMMs 110 and the heat spreader 124 (and the associated heat pipe 118) to improve heat transfer efficiency. In some examples, the thermal interface material 1012 is affixed to the DIMMs 110. In some examples, the thermal interface material 1012 is affixed to the heat spreader 124 (and the heat pipe 118). In some examples, the thermal interface material 1012 is omitted.

As mentioned above and shown in the illustrated example of FIG. 10, the heat pipe 118 is relatively flat or narrow with a width or height 1014 that is greater than the thickness 1010. In some examples, the height 1014 of the heat pipe 118 is multiples times (e.g., at least 2 times, at least 3 times, at least 4 times, at least 5 times, at least 6 times, at least 7 times, at least 8 times, etc.) the thickness 1010. In some examples, the height 1014 of the heat pipe 118 is approximately 0.34 inches e.g., 0.34 +/- 0.005 inches) corresponding to approximately 8.7 mm. However, the heat pipe 118 can have any other suitable height 1014. Further, in some examples, the width or height 1016 of the heat spreader 124 is greater than the height 1014 of the heat pipe 118. In some examples, the height 1016 of the heat spreader 124 is multiples times (e.g., at least 2 times, at least 3 times, at least 4 times, etc.) the height 1014 of the heat pipe 118. In some examples, any of the dimensions 1002, 1004, 1006, 1008, 1010, 1014, 1016 shown in FIG. 10 can be larger and/or smaller than what is shown and/or described above.

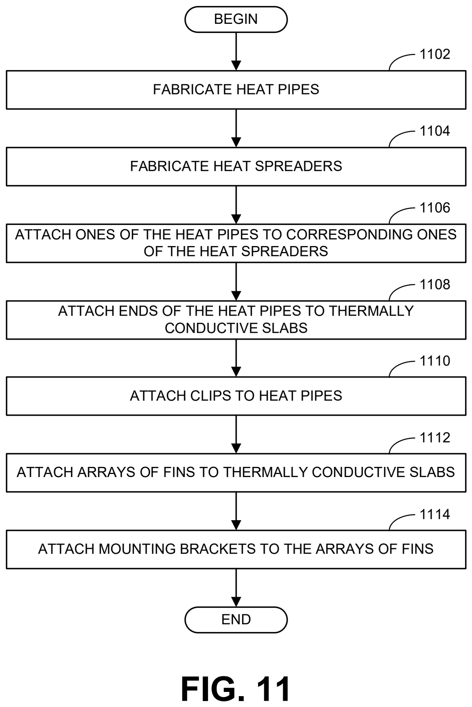

FIG. 11 is a flowchart representative of an example method of manufacturing the example heat sink assembly 116 of FIGS. 1-10. In some examples, some or all of the operations outlined in the example method of FIG. 11 are performed automatically by fabrication equipment that is programmed to perform the operations. Although the example method of manufacture is described with reference to the flowchart illustrated in FIG. 11, many other methods may alternatively be used. For example, the order of execution of the blocks may be changed, and/or some of the blocks described may be combined, divided, rearranged, omitted, eliminated, and/or implemented in any other way. Further, in some examples, additional processing operations can be performed before, between, and/or after any of the blocks represented in the illustrated example.

The example method of FIG. 11 begins at block 1102 that involves fabricating heat pipes 118. At block 1104, the example method involves fabricating heat spreaders 124. In some examples, the heat spreaders 124 are fabricated with a recessed region dimensioned to receive one of the heat pipes 118. At block 1106, the example method involves attaching ones of the heat pipes 118 to corresponding ones of the heat spreaders 124. At block 1108, the example method involves attaching ends of the heat pipes 118 to thermally conductive slabs 126, 128. At block 1110, the example method involves attaching clips to the heat pipes 118. At block 1112, the example method involves attaching arrays of fins 130, 132, 302 to the thermally conductive slabs 126, 128. At block 1114, the example method involves attaching mounting brackets to the arrays of fins 130, 132, 302. Thereafter, the example method of manufacture ends.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

As used herein "substantially real time" refers to occurrence in a near instantaneous manner recognizing there may be real world delays for computing time, transmission, etc. Thus, unless otherwise specified, "substantially real time" refers to real time + 1 second.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, apparatus, articles of manufacture, and methods have been disclosed that enhance the cooling of DIMMs on a motherboard of a server. Such cooling enhancements can enable the DIMMs to be placed closer together so as to take up less space, thereby permitting more space for larger processor chips. Disclosed example heat sink assemblies include heat spreaders and flattened heat pipes positioned on either side of the DIMMs with the heat pipes extending beyond both ends of the DIMMs between corresponding arrays of fins aligned with a direction of airflow of cooled air. While the heat sink assemblies can lead to higher airflow impedance, the cooling efficiency is significantly improved over direct air cooling of DIMMs without such heat sink assemblies. Disclosed systems, apparatus, articles of manufacture, and methods are accordingly directed to one or more improvement(s) in the operation of a machine such as a computer or other electronic and/or mechanical device.

Further examples and combinations thereof include the following:
Example 1 includes an apparatus comprising a heat pipe to extend between first and second dual in-line memory modules (DIMMs), a first end of the heat pipe to extend beyond a first end of the first and second DIMMs, a second end of the heat pipe to extend beyond a second end of the first and second DIMMs, and an array of fins thermally coupled to the first end of the heat pipe.
Example 2 includes any preceding clause(s) of example 1, wherein the fins extend in planes substantially parallel to the first and second DIMMs.
Example 3 includes any preceding clause(s) of any one or more of examples 1-2, wherein the heat pipe has a thickness, a height, and a length, the height multiple times greater than the thickness, the length multiple times greater than the height.
Example 4 includes any preceding clause(s) of any one or more of examples 1-3, including a heat spreader to extend between the first and second DIMMs, the heat spreader having a first thickness dimensioned to extend between the first DIMM and the heat pipe, the heat spreader having a second thickness greater than the first thickness at a location spaced apart from the heat pipe, the second thickness to extend between the first DIMM and the second DIMM.
Example 5 includes any preceding clause(s) of any one or more of examples 1-4, including a first thermal interface material to be between the heat spreader and the first DIMM, the first thermal interface material to contact both the heat spreader and the first DIMM, and a second thermal interface material to be between the heat spreader and the second DIMM and between the heat pipe and the second DIMM, the second thermal interface material to contact each of the heat spreader, the heat pipe, and the second DIMM.
Example 6 includes any preceding clause(s) of any one or more of examples 1-5, wherein the array of fins is a first array of fins, and the apparatus includes a second array of fins thermally coupled to the second end of the heat pipe.
Example 7 includes any preceding clause(s) of any one or more of examples 1-6, wherein the array of fins is a first array of fins, and the apparatus includes a second array of fins extending from the first array of fins.
Example 8 includes any preceding clause(s) of any one or more of examples 1-7, wherein ones of the fins in the second array of fins are continuous extensions of corresponding ones of the fins in the first array of fins.
Example 9 includes any preceding clause(s) of any one or more of examples 1-8, wherein the second array of fins is smaller than the first array of fins.
Example 10 includes any preceding clause(s) of any one or more of examples 1-9, wherein the second array of fins is to be closer to the first and second DIMMs than the first array of fins is to be to the first and second DIMMs.
Example 11 includes any preceding clause(s) of any one or more of examples 1-10, including a mounting bracket, the first array of fins attached to the mounting bracket, the mounting bracket including a raised platform, the second array of fins attached to the raised platform.
Example 12 includes any preceding clause(s) of any one or more of examples 1-11, including the first and second DIMMs, and a circuit board supporting DIMM slots, the first and second DIMMs to be inserted in the slots, the first and second DIMMs to be spaced at a pitch of less than example 0 includes 29 inches.
Example 13 includes any preceding clause(s) of any one or more of examples 1-12, including a mounting bracket attached to the array of fins, the mounting bracket having a mounting hole that aligns with corresponds holes in a circuit board, the corresponding holes in the circuit board to be used to mount a voltage regulator component to the circuit board.
Example 14 includes any preceding clause(s) of any one or more of examples 1-13, wherein the first and second DIMMs are included in an array of multiple DIMMs, and the heat pipe is one of an array of heat pipes, different ones of the heat pipes between respective pairs of the DIMMs.
Example 15 includes any preceding clause(s) of any one or more of examples 1-14, wherein outermost DIMMs of the array of multiple DIMMs to be sandwiched between corresponding ones of the heat pipes in the array of heat pipes.
Example 16 includes an apparatus comprising a heat pipe, a first array of fins thermally coupled to a first end of the heat pipe, and a second array of fins thermally coupled to a second end of the heat pipe, the first and second arrays of fins to be mounted to a circuit board adjacent opposing ends of an array of dual in-line memory modules (DIMMs) inserted in slots on the circuit board, the heat pipe to extend between an adjacent pair of the DIMMs.
Example 17 includes any preceding clause(s) of example 16, including a first thermally conductive slab thermally coupling the heat pipe to the first array of fins, and a second thermally conductive slab thermally coupling the heat pipe to the second array of fins.
Example 18 includes an apparatus comprising a motherboard having a bank of dual in-line memory module (DIMM) slots, and a heat sink assembly to be attached to the motherboard, the heat sink assembly including heat pipes to extend along either side of DIMMs inserted into the DIMM slots, and heat spreaders to extend along either side of DIMMs adjacent to the heat pipes, the heat pipes longer than the heat spreaders.
Example 19 includes any preceding clause(s) of example 18, wherein a height of the heat spreaders is greater than a height of the heat pipes.
Example 20 includes any preceding clause(s) of any one or more of examples 18-19, including a clip to structurally connect different ones of the heat pipes at a location between ends of the heat pipes and the DIMM slots.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. An apparatus comprising:
a heat pipe to extend between first and second dual in-line memory modules (DIMMs), a first end of the heat pipe to extend beyond a first end of the first and second DIMMs, a second end of the heat pipe to extend beyond a second end of the first and second DIMMs; and
an array of fins thermally coupled to the first end of the heat pipe.

2. The apparatus of claim 1, wherein the fins extend in planes substantially parallel to the first and second DIMMs.

3. The apparatus of any one of claims 1-2, wherein the heat pipe has a thickness, a height, and a length, the height multiple times greater than the thickness, the length multiple times greater than the height.

4. The apparatus of any one of claims 1-3, including a heat spreader to extend between the first and second DIMMs, the heat spreader having a first thickness dimensioned to extend between the first DIMM and the heat pipe, the heat spreader having a second thickness greater than the first thickness at a location spaced apart from the heat pipe, the second thickness to extend between the first DIMM and the second DIMM.

5. The apparatus of claim 4, including:
a first thermal interface material to be between the heat spreader and the first DIMM, the first thermal interface material to contact both the heat spreader and the first DIMM; and
a second thermal interface material to be between the heat spreader and the second DIMM and between the heat pipe and the second DIMM, the second thermal interface material to contact each of the heat spreader, the heat pipe, and the second DIMM.

6. The apparatus of any one of claims 1-5, wherein the array of fins is a first array of fins, and the apparatus includes a second array of fins thermally coupled to the second end of the heat pipe.

7. The apparatus of any one of claims 1-6, wherein the array of fins is a first array of fins, and the apparatus includes a second array of fins extending from the first array of fins.

8. The apparatus of claim 7, wherein ones of the fins in the second array of fins are continuous extensions of corresponding ones of the fins in the first array of fins.

9. The apparatus of any one of claims 7-8, wherein the second array of fins is smaller than the first array of fins.

10. The apparatus of any one of claims 7-9, wherein the second array of fins is to be closer to the first and second DIMMs than the first array of fins is to be to the first and second DIMMs.

11. The apparatus of any one of claims 7-10, including a mounting bracket, the first array of fins attached to the mounting bracket, the mounting bracket including a raised platform, the second array of fins attached to the raised platform.

12. The apparatus of any one of claims 1-11, including:
the first and second DIMMs; and
a circuit board supporting DIMM slots, the first and second DIMMs to be inserted in the slots, the first and second DIMMs to be spaced at a pitch of less than 0.29 inches.

13. The apparatus of any one of claims 1-12, including a mounting bracket attached to the array of fins, the mounting bracket having a mounting hole that aligns with corresponds holes in a circuit board, the corresponding holes in the circuit board to be used to mount a voltage regulator component to the circuit board.

14. The apparatus of any one of claims 1-13, wherein the first and second DIMMs are included in an array of multiple DIMMs, and the heat pipe is one of an array of heat pipes, different ones of the heat pipes between respective pairs of the DIMMs.

15. The apparatus of claim 14, wherein outermost DIMMs of the array of multiple DIMMs to be sandwiched between corresponding ones of the heat pipes in the array of heat pipes.
